# EUROPÄISCHE PATENTSCHRIFT

(11) **EP 0 682 719 B1**
(45) Veröffentlichungstag und Bekanntmachung des Hinweises auf die Patenterteilung: **27.05.1998**
(21) Anmeldenummer: 94904952.2
(22) Anmeldetag: 22.01.1994
(51) Int. Cl.: C23C 16/50, C23C 16/32, C23C 16/34, C23C 16/40

(54) **VORRICHTUNG UND VERFAHREN ZUR ABLAGERUNG VON FESTEN STOFFEN, INSBESONDERE VON SEHR FEINKÖRNIGEN STOFFEN, SOWIE VERWENDUNG DIESES VERFAHRENS**
DEVICE AND PROCESS FOR DEPOSITING SOLID MATERIALS, IN PARTICULAR VERY FINE-GRAINED MATERIALS, AND USE OF SAID PROCESS
DISPOSITIF ET PROCEDE PERMETTANT LE DEPOT DE MATIERES SOLIDES, NOTAMMENT DE MATIERES A GRAINS EXTREMEMENT FINS ET UTILISATION DUDIT PROCEDE

(30) Priorität: 06.02.1993 DE 4303492
(43) Veröffentlichungstag der Anmeldung: 22.11.1995
(73) Patentinhaber: Widia GmbH, 45145 Essen (DE)
(72) Erfinder: KÖNIG, Udo, D-45149 Essen (DE); TABERSKY, Ralf, D-46240 Bottrop (DE)
(74) Vertreter: Vomberg, Friedhelm, Dipl.-Phys.
(86) Internationale Anmeldenummer: DE9400047
(87) Internationale Veröffentlichungsnummer: WO9418357

(56) Entgegenhaltungen:
- EP-A- 0 064 884
- DE-A- 3 841 730
- DE-C- 3 433 874
- Patent Abstracts of Japan, Band 15, Nr 421(C-878); & JP,A,03173776 (SUMITOMO ELECTRIC IND LTD), 1991-07-29
- Patent Abstracts of Japan, Band 9, Nr 278(C-312); & JP,A,60125374 (TOSHIBA K.K.), 1985-07-04

## Beschreibung

Die Erfindung betrifft eine Vorrichtung zur Ablagerung von festen Stoffen, insbesondere von feinkörnigen Stoffen, durch einen plasmachemischen Prozeß aus gasförmigen Metallchloriden, Wasserstoff, Sauerstoff und/oder Stickstoff und/oder einem kohlenstoffhaltigen Gas in einem durch eine Glimmentladung ionisierten reaktiven Gasgemisch, mit einem Reaktionsgefäß, in das eine Gaszufuhrleitung mit mehreren Ausströmöffnungen mündet. Die Erfindung betrifft ferner ein Verfahren zur Abscheidung von festen Stoffen unter Anwendung eines durch eine Glimmentladung aktivierten CVD-Verfahrens mittels gasförmigen Metallchloriden, Wasserstoff, Sauerstoff und/oder Stickstoff und/oder einem kohlenstoffhaltigen Gas, das mit einer hohen Geschwindigkeit in den Reaktionsraum geführt wird, in dem ein konstanter Arbeitsdruck aufrechterhalten wird.

Das sogenannte CVD-Verfahren, bei dem aus gasförmigen Reaktionsstoffen ein fester Stoff gebildet wird, wird üblicherweise zur Abscheidung von TiC oder TiN unter Einleitung von Titanchlorid und Wasserstoff und Methan oder Stickstoff als Kohlenstoff bzw. Stickstofflieferant seit längerem verwendet. Ebenso ist es bekannt, Aluminiumchlorid sowie Kohlendioxid als Donatoren für die Al₂O₃-Abscheidung zu verwenden. Man kann die Prozeßparameter beim CVD-Verfahren auch so wählen, daß sich kein fest haftender Niederschlag, sondern lose Ablagerungen (Pulver) bilden. Das CVD-Verfahren wird in beheizten Reaktionsräumen, zum Teil bei Unterdruck durchgeführt. Je nach Konzentration der Reaktionspartner im Trägergas sowie der Temperatur und der Strömungsgeschwindigkeit ergeben sich unterschiedliche Abscheideraten, Zusammensetzungen und Strukturen bzw. Texturen der Schicht.

Insbesondere ist auch das Plasma-CVD-Verfahren von Bedeutung, das bei niedrigen Temperaturen durchgeführt werden kann. überlagert man dem Reaktionsgas in einer Niederdruckglimmentladung ein Nichtgleichgewichtsplasma, so werden die in dem Gas vorhandenen Ladungsträger unter dem Einfluß des bestehenden elektrischen Feldes beschleunigt. Abhängig von der Teilchendichte bzw. dem Druck bestimmt sich auch die freie Weglänge zwischen zwei Zusammenstößen. Reicht die Teilchenenergie bei der angelegten Spannung aus, können Moleküle oder Atome zur Dissoziierung oder Ionisierung angeregt werden, wodurch chemische Reaktionen möglich werden, die ansonsten nur bei höheren Temperaturen ablaufen könnten. Prinzipiell werden Niederdruckplasmen durch Anlegen einer konstanten Gleichspannung an einem als Kathode geschalteten Werkstück oder durch eine hochfrequente Wechselspannung oder durch eine gepulste Gleichspannung erzeugt, die beispielsweise in der DE 38 41 731 A1 beschrieben wird.

In der US-A-4 909 183 wird zunächst eine evakuierbare Kammer beschrieben, in deren Mitte eine rotationsfähige Halterung für das Beschichtungssubstrat angeordnet ist. Das Substrat selbst wird von einer zylinderförmigen kathodischen Elektrode umgeben, die mit einer HF-Spannungsquelle verbunden ist. Das Substrat dient als Anode, so daß bei angelegter Spannung an der Kathode ein Niederdruckplasma entsteht. Nachteiligerweise scheidet sich hierbei der Stoff auf der Kathode mit den Gasaustrittsöffnungen ab, so daß nach kurzer Zeit der Gasfluß empfindlich gestört wird.

Die US-A-4 991 542 beschreibt eine Reaktionskammer, in deren Mitte ein mit einer HF-Quelle verbundener Substratkörper angeordnet ist, zu dessen Seiten diametral gegenüberstehende, gleichzeitig als Gaszufuhreinrichtungen dienende Elektroden angeordnet sind. Die Elektroden sind trichterförmig aufgebaut und besitzen etwa in Form einer Dusche mehrere Gasausströmlöcher an der dem Substrat zugewandten Seite. Anstelle die Spannungsquelle mit dem Substrat bzw. dem Substrathalter zu verbinden, kann diese auch mit Gitterelektroden verbunden sein, die jeweils beidseitig zwischen dem Substrat und der gasduschenartig ausgebildeten Elektrode angeordnet sind.

Aus der EP 0 257 620 A2 sind ferner ein Verfahren und eine Vorrichtung zum Ausbilden einer Schicht durch plasmachemischen Prozeß bekannt, wobei zumindest drei vorzugsweise an einer Hochfrequenzquelle angelegte Elektroden verwendet werden, die in einem evakuierbaren und mit Gas beschickbaren Reaktionsraum angeordnet sind. Die Substratfläche soll vollständig oder nahezu vollständig parallel zu dem zwischen den Elektroden ausgebildeten elektrischen Feld verlaufen. Das zur Ausbildung der Schicht erforderliche Gas soll zwischen den und/oder durch die Elektroden unmittelbar auf die Fläche strömen. Das Potential von aufeinanderfolgenden Elektroden soll gleichmäßig ansteigen. Die Elektroden bilden eine Umhüllende, die den Verlauf des zwischen den Elektroden sich ausbildenden elektrischen Feldes entspricht. Die Elektroden können hohlzylinderförmig ausgebildet sein und Austrittsöffnungen für das Gas aufweisen. Möglich sind auch Ringelektroden, die koaxial zu dem die Fläche aufweisenden Substrat wie Zylinder angeordnet sind oder Elektroden, die auf der Umfangsfläche eines Zylinders angeordnet sind.

Aus der EP 0 503 820 A1 sind Vorrichtungen zur Plasma-CVD-Beschichtung bekannt, die mehrere hohlzylindrische Gaszuführungen aufweisen, die als Kathode geschaltet sind und einen Innendurchmesser von ca. 1,9 cm und eine Länge von 38,8 cm aufweisen. Die Gaszuführungshohlzylinder besitzen mehrere Reihen von Austrittöffnungen mit jeweils sechs einzelnen nebeneinander auf einer Geraden angeordneten einzelnen öffnungen. Angaben über die Größe der öffnungen werden nicht gemacht.

Der Einströmgeschwindigkeitsgradient für das Reaktionsgas soll nach dem in der EP 0 402 675 A1 beschriebenen Verfahren größer als 1050 cm/(cm · sec) sein.

Die JP-A-3-173776 beschreibt eine Beschichtungseinrichtung mit zylindrischen Elektroden, die koaxial zueinander angeordnet sind, wobei die innere Elektrode aus einem Metallnetzwerk und die äußere Elektrode aus einem Metallvollkörper besteht. Die innere Elektrode ist mit einer HF-Spannungsquelle verbunden, während die äußere Elektrode geerdet ist. Zusätzlich kann auf die äußere Elektrode eine Gleichspannung gegeben werden. Die zu beschichtenden Materialien werden mit der äußeren Elektrode verbunden.

Es ist Aufgabe der vorliegenden Erfindung, eine Vorrichtung und ein Verfahren anzugeben, bei denen sich eine gleichmäßige Gasverteilung im Reaktor einstellt, ohne daß die Gefahr besteht, daß die Austrittsöffnungen in der Gaszuführung verstopft werden. Der hierzu erforderliche konstruktive und/oder verfahrenstechnische Aufwand soll möglichst gering sein.

Vorrichtungstechnisch wird diese Aufgabe durch die im Anspruch 1 beschriebene Vorrichtung gelöst. Diese besitzt eine Gaszufuhrleitung, die sich als mindestens ein länglicher Hohlkörper (mit einer großen Anzahl von Austrittsöffnungen mit jeweils einem maximalen Querschnitt von 2 mm²) und einem bezogen auf den Querschnitt der Austrittsöffnungen mehr als 100fachen Querschnitt in das Reaktionsgefäß erstreckt, wobei der sich auf Erdpotential befindliche zylindrische Hohlkörper von einem als Kathode geschalteten Netzwerk oder einer mit vielen Öffnungen flächenartigen Struktur umhüllt wird, d.h., der Quotient Querschnitt des Einzelloches / Querschnitt des Hohlkörpers <1/100.

Die Ablagerungen sind nach der Erfindung pulverförmige feste Teilchen oder auch lose oder fest haftende Niederschläge auf der Kathode. Aus den gewonnenen pulverförmigen, äußerst feinteiligen Stoffen können durch nach dem Stand der Technik im Prinzip bekannte keramische Sinterprozesse Werkstoffe mit hochwertigen technischen Eigenschaften hergestellt werden. Bei der vorliegenden Erfindung wird die grundsätzlich bekannte chemische Gasphasenreaktion ausgenutzt. Beispielsweise ist es nach dem Stand der Technik bekannt, feinteiliges Aluminiumoxidpulver unter folgenden Bedingungen zu gewinnen:

Bei einer Temperatur von 1010°C und einem Druck von 101,2 kPa wird ein aus 4 Massen-% Aluminiumchlorid, 12 Massen-% Kohlendioxid und 84 Massen-% Wasserstoff bestehendes Gemisch in die Reaktionskammer eingeleitet. Durch die bekannte chemische Reaktion entsteht Aluminiumoxidpulver mit mittleren Korngrößen von etwa 300 bis 500 nm Durchmesser. Um noch feinteiligere Pulver zu erhalten, kann die Reaktionstemperatur minimiert werden, allerdings geht die Reaktionsausbeute auf ein geringeres Maß zurück. Mit der vorliegenden Erfindung ist es möglich, bei niedrigeren Temperaturen ab ca. 500°C an aufwärts sehr feinteilige Ablagerungen zu erzeugen. Zur Beschleunigung der chemischen Reaktion wird dem reaktiven Gasgemisch ein Plasmazustand überlagert. Bei einer im Gasraum erzeugten Glimmentladung wird ein bestimmter Anteil der Gasmoleküle durch Elektronenstöße ionisiert oder fragmentiert. Durch diese Aktivierung des reaktiven Gases kann die chemische Reaktion zur Bildung des festen Niederschlages bereits bei niedrigeren Temperaturen ablaufen. Darüber hinaus wird die besondere Schwierigkeit überwunden, daß hinreichend hohe elektrische Feldstärken zur Erzeugung einer großen Ionisierungsdichte bisher nur in unmittelbarer Nähe der Kathode vorhanden sind (sogenannter Kathodenfall). Eine unkontrollierte Durchströmung einer Kathode durch das reaktive Gas reicht alleine nicht aus. Wesentlich ist ferner die vorbeschriebene Dimensionierung, die eine sehr genaue dosierte und fein verteilte auf die plasmachemische Reaktion abgestimmte Zuführung des reaktiven Gasgemisches ermöglicht.
Überraschenderweise verengen sich die vielen kleinen AustrittsÖffnungen auch nach vielstündigem Betrieb der Vorrichtung nicht, erst recht wurde ein Zusetzen verhindert, obwohl die Öffnungen ständig von einer hochreaktiven Gasmischung durchströmt wurden. Alle anderen der reaktiven Gasatmosphäre ausgesetzten Teile werden bei dem Verfahrensablauf hingegen mit einem festen Überzug versehen, also auch das sich auf Erdpotential befindliche Äußere des mit Öffnungen versehenen zylindrischen Hohlkörpers bzw. der Hohlkörper.

Weitere Ausgestaltungen der Erfindung sind in den Unteransprüchen beschrieben. So wird vorzugsweise der Hohlkörper einen inneren freien Querschnitt von mehr als 200 mm² besitzen und mit mehr als 400 Austrittsöffnungen mit einem jeweiligen Querschnitt von weniger als 1 mm² versehen sein. Nach der vorliegenden Erfindung ist es sowohl möglich, einen einzigen Hohlkörper zentrisch in dem Reaktionsgefäß oder mehrere Hohlkörper anzuordnen. Die Hohlkörper können entweder zylindrisch, im Querschnitt oval oder auch mehreckig, insbesondere sechseckig ausgebildet sein.

Die Aufgabe wird ferner durch das im Anspruch 5 beschriebene Verfahren gelöst. Die Ausströmgeschwindigkeit beträgt mehr als 50 m/sec bei einem radial auswärts gerichteten Gasstrom gekennzeichnet ist. Der Arbeitsdruck liegt bei einer weiteren Ausgestaltung der Erfindung zwischen 100 bis 500 Pa. Die Gasausströmgeschwindigkeit wird möglichst hoch, insbesondere größer als 200 m/sec gewählt.

Schließlich wird nach einer weiteren Ausbildung der Erfindung an das Netzwerk eine gepulste Gleichspannung angelegt. Die Verfahrenstechnik hierzu ist prinzipiell in der DE 38 41 730 A1 beschrieben.

Erfindungsgemäß wird das beschriebene Verfahren zur Ablagerung von feinteiligen Pulvern aus Oxiden, Carbiden und Nitriden, insbesondere aus Aluminiumoxid, Titancarbid und Titannitrid, oder zur Abscheidung von fest haftenden Überzügen aus Oxiden, Carbiden und Nitriden, insbesondere Aluminiumoxid, Titancarbid und Titannitrid, verwendet.

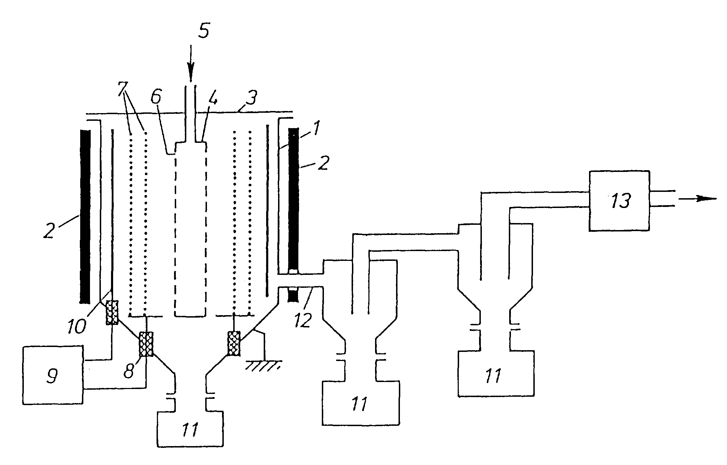

Ein Ausführungsbeispiel der Erfindung ist in der Zeichnung dargestellt, die eine schematische Schnittansicht einer erfindungsgemäßen Vorrichtung darstellt.

Das als Vakuumgefäß 1 ausgebildete Reaktionsgefäß kann durch eine elektrische Widerstandsheizung 2 beheizt werden. Im Deckel 3 des Vakuumgefäßes ist ein zylindrischer Hohlkörper 4 eingebaut, der sich ebenso wie das Vakuumgefäß 1 auf Erdpotential befindet. Das reaktive Gasgemisch wird durch die Leitung 5 dem zylindrischen Hohlkörper 4 zugeführt. Der zylindrische Hohlkörper 4 besitzt in seinem Mantel äquidistante Öffnungen 6, die einen jeweiligen Querschnitt von 0,79 mm² besitzen. Insgesamt besitzt der zylindrische Hohlkörper 4 510 solcher öffnungen. Um den zylindrischen Hohlkörper 4 ist mindestens ein Drahtnetz 7 (im vorliegenden Fall zwei Drahtnetze 7) aus korrosionsbeständigem Stahl angeordnet, die über eine Stromdurchführung 8 mit einer Stromversorgung 9 zur Erzeugung einer gepulsten Gleichspannung verbunden sind. Die Drahtnetze 7 sind als Kathode geschaltet. Als Anode dient ein zylindrisch geformtes Blech 10, das rings um das Drahtnetz 7 angeordnet ist. Unterhalb des Vakuumbehälters befindet sich ein Behälter 11 zum Auffangen des pulverförmigen Reaktionsproduktes. Weitere Behälter 11 befinden sich in der Abgasleitung 12 zwischen dem Vakuumgefäß 1 und der Vakuumpumpe 13. Auch über diese Behälter 11 werden Pulveranteile aus dem Gasstrom extrahiert. Das gesamte Vakuumgefäß mit Hohlkörper, Drahtnetz und Anodenblech ist konzentrisch um den Hohlkörper 4 aufgebaut.

In einem speziellen Versuchsbeispiel wurden bei 650°C und einem Druck von 350 Pa 1200 l/h eines Reaktionsgases durch den zylindrischen Hohlkörper und die dortigen Ausströmöffnungen 6 mit einer Strömungsgeschwindigkeit von 240 m/s eingeführt. Das Gas setzte sich aus 8 Massen-% Aluminiumchlorid, 15 Massen-% Kohlendioxid und 77 Massen-% Wasserstoff zusammen. Die Stromversorgung lieferte einen gepulsten Gleichstrom mit einer maximalen Pulsspannung von 700 V und einem Pulsstrom von 22 A bei einer Pulsdauer von 600 µs und einer Pulspause von 100 µs. Das Verfahren wird so durchgeführt, daß der größere Anteil des festen Reaktionsproduktes als Pulver anfällt und in den Sammelgefäßen 11 aufgefangen wird. Der verbleibende Anteil liegt lose oder fest auf dem als Kathode geschalteten Netzwerk und kann nach Ende des Verfahrens abgeschüttelt oder durch Verformung der elastischen Netze gelöst werden. Die gewonnenen Aluminiumoxidpulver wurden elektronenmikroskopisch untersucht und analysiert. Die festzustellenden Korngrößen des Aluminiumoxids lagen zwischen 50 bis 200 nm.

Das erfindungsgemäße Verfahren eignet sich insbesondere zur Herstellung von feinteiligen oxidischen Pulvern. Bei Verwendung von Gasgemischen zur Ablagerung von Nitriden oder Carbiden ist der als Pulver anfallende Anteil geringer. Bei der Verwendung von Gasgemischen aus Titantetrachlorid, Methan und Wasserstoff entstehen überwiegend fest auf den Netzkathoden 7 haftende Niederschläge. In solchen Fällen bleibt die Ausbeute an Pulver auch bei Verwendung von Metalldonator-reichen Gasgemischen relativ gering. Ein Zuwachsen der kleinen Gasdurchtrittsöffnungen 6, das bei Verfahren nach dem Stand der Technik häufig zu beobachten war, wurde auch bei den Versuchen zur Ablagerung von Metallcarbiden und Metallnitriden nicht beobachtet, sofern die erfindungsgemäßen Merkmale eingehalten worden sind.

In den Versuchen wurde festgestellt, daß sich bei Gasmischungen mit geringem Sättigungsgrad des Metallchlorides auch fest haftende Überzüge an den kathodisch geschalteten Gitterstrukturen und an dort befestigten Substratkörpern, z.B. aus Hartmetall, Cermets oder Schnellarbeitsstählen, bilden können. Auf diese Beobachtung richtet sich ein Verwendungsanspruch des Verfahrens.

## Patentansprüche

1. Vorrichtung zur Ablagerung von festen Stoffen unter Anwendung eines durch eine Glimmentladung aktivierten CVD-Verfahrens mittels gasförmigen Metallchloriden, Wasserstoff, Sauerstoff und/oder Stickstoff und/oder einem kohlenstoffhaltigen Gas in einem durch eine Glimmentladung ionisierten reaktiven Gemisch, mit einem Reaktionsgefäß (1), in das eine Gaszufuhrleitung (5)mit mehreren Ausströmöffnungen (6) mündet,
**dadurch gekennzeichnet,**
daß die Gaszufuhrleitung sich als mindestens ein länglicher Hohlkörper (4) mit einer großen Anzahl von Austrittsöffnungen (6) mit jeweils einem maximalen Querschnitt von 2 mm² und einem bezogen auf den Querschnitt der Austrittsöffnungen (6) mehr als 100fachen Querschnitt in das Reaktionsgefäß erstreckt, wobei der sich auf Erdpotential befindliche Hohlkörper (4) von einem als Kathode geschalteten Netzwerk (7) oder einer als Kathode geschalteten mit vielen Öffnungen versehenen flächenartigen Struktur umhüllt wird und die Gaszufuhr auf Erdpotential und die Reaktionsgefäßwandung (1) anodisch geschaltet sind, so daß das als Pulver anfallende Reaktionsprodukt auf dem als Kathode geschalteten Netzwerk oder der flächenartigen Struktur oder an dort befestigten Substratkörpern abscheidbar ist.

2. Vorrichtung nach Anspruch 1, dadurch gekennzeichnet, daß der Hohlkörper (4) einen inneren freien Querschnitt von mehr als 200 mm² besitzt und mit mehr als 400 Austrittsöffnungen mit einem jeweiligen Querschnitt von weniger als 1 mm² versehen ist.

3. Vorrichtung nach Anspruch 1 oder 2, dadurch gekennzeichnet, daß mehrere Hohlkörper (4) in dem Reaktionsgefäß (1) angeordnet sind.

4. Vorrichtung nach einem der Ansprüche 1 bis 3, dadurch gekennzeichnet, daß der oder die Hohlkörper (4) zylindrisch, im Querschnitt oval oder mehreckig, insbesondere viereckig sind.

5. Verfahren zur Ablagerung von festen Stoffen unter Anwendung eines durch eine Glimmentladung aktivierten CVD-Verfahrens mittels gasförmigen Metallchloriden, Wasserstoff, Sauerstoff und/oder Stickstoff und/oder einem kohlenstoffhaltigen Gas, das mit einer hohen Geschwindigkeit in den Reaktionsraum geführt wird, in dem ein konstanter Arbeitsdruck aufrechterhalten wird, dadurch gekennzeichnet, daß das Gas mit einer Geschwindigkeit von mehr als 50 m/sec in den Reaktionsraum eingeführt und radial auswärts über einen länglichen Hohlkörper (4) eingeleitet wird, wobei die Gaszufuhr auf Erdpotential, ein koaxial hierum angeordnetes Netzwerk (7) oder einer mit vielen Öffnungen versehenen flächenartigen Struktur kathodisch und die Reaktionsgefäßwandung (1) anodisch geschaltet sind, so daß das als Pulver anfallende Reaktionsprodukt auf dem als Kathode geschalteten Netzwerk oder der flächenartigen Struktur oder an dort befestigten Substratkörpern abgeschieden wird.

6. Verfahren nach Anspruch 5, dadurch gekennzeichnet, daß der Arbeitsdruck zwischen 100 bis 500 Pa und die Gasausströmgeschwindigkeit bei mehr als 200 m/sec liegt.

7. Verfahren nach Anspruch 5 oder 6, dadurch gekennzeichnet, daß an das Netzwerk (7) eine gepulste Gleichspannung angelegt wird.

8. Verwendung des Verfahrens nach den Ansprüchen 1 bis 7 zur Ablagerung von feinteiligen Pulvern aus Oxiden, Carbiden und Nitriden.

9. Verwendung des Verfahrens nach den Ansprüchen 1 bis 7 zur Ablagerung von fest haftenden Überzügen aus Oxiden, Carbiden und Nitriden.

10. Verwendung nach den Ansprüchen 8 oder 9 zur Ablagerung von fest haftenden Überzügen aus Aluminiumoxid, Titancarbid und Titannitrid.

## Claims

1. Device for depositing solid materials using in a CVD-process activated by a glow discharge gaseous metal chlorides, hydrogen, oxygen, and/or nitrogen and/or carbon-containing gas in a reaction mixture ionised by glow discharge, with a reaction vessel (1) into which a gas input (5) leads with a plurality of outlet apertures (6),
characterised in that
the gas input conduit extends as at least one elongated hollow body (4) with a large number of outlet apertures (6) each with a maximum cross-sectional area of 2 mm² and with a cross section more than 100 times greater than the cross section of the outlet apertures (6), the hollow body (4) being at earth potential and surrounded by a cathodically connected network (7) or a cathodically connected flat structure formed with many openings and the gas inlet being at earth potential and the wall of the reaction vessel connected anodically, that the powdery reaction output deposits onto the cathodically connected network or onto the flat structure or onto substrate bodies fixed there.

2. Device according to claim 1, characterised in that the hollow body (4) has an inner free cross section of more than 200 mm² and is provided with more than 400 outlet apertures each having a cross section of less than 1 mm².

3. Device according to claim 1 or 2, characterised in that several hollow bodies (4) are provided in the reaction vessel (1).

4. Device according to one of claims 1 to 3, characterised in that the hollow body(ies) is (are) cylindrical, in section, oval, or polygonal, in particular rectangular.

5. Process for depositing solid materials by using a glow-discharge activated CVD method by means of metal chlorides, hydrogen, oxygen, and/or nitrogen and/or a carbon-containing gas that is fed at high speed into a reaction chamber in which a constant working pressure is maintained, characterised in that the gas is fed into the reaction chamber with a speed of more than 50 m/sec and is directed radially outwardly through a elongated hollow body (4), the gas feed being at earth potential, a coaxially surrounding network (7) or a flat structure formed with many apertures acting as cathode and the reaction vessel wall (1) acting as anode, so that the powdery reaction output deposits onto the cathodically connected network or onto the flat structure or onto substrate bodies fixed there.

6. Process according to claim 5, characterised in that the working pressure is between 100 to 500 Pa and the gas-flow velocity is more than 200 m/sec.

7. Process according to claim 5 or 6, characterised in that a pulsed direct-current voltage is fed to the network (7).

8. Use of the process according to claims 1 to 7 for depositing very fine powders of oxides, carbides, and nitrides.

9. Use of the process according to claims 1 to 7 for depositing of solid adhering layers of oxides, carbides, and nitrides.

10. Use according to claim 8 or 9 for depositing of solid adhering layers of aluminium oxide, titanium carbide, and titanium nitride.

## Revendications

1. Dispositif permettant le dépôt de matières solides, utilisant un procédé CVD activé par décharge lumineuse au moyen de chlorures métalliques gazeux, d'hydrogène, d'oxygène et/ou d'azote et/ou d'un gaz contenant du carbone dans un mélange réactif ionisé par une décharge lumineuse, comprenant un réacteur (1) dans lequel débouche une conduite d'admission de gaz (5) avec plusieurs orifices d'échappement (6),
**caractérisé par le fait**
que la conduite d'admission de gaz s'étend dans le réacteur comme au moins un corps creux allongé (4) présentant un nombre élevé d'orifices d'échappement (6) avec respectivement une section maximale de 2 mm², et une section qui, par rapport à la section des orifices d'échappement (6), est plus de 100 fois plus grand, le corps creux (4) mis au potentiel terrestre étant enveloppé d'un treillis (7) connecté en tant que cathode ou d'une structure ayant l'aspect d'une surface, qui est pourvue de beaucoup d'orifices et connectée comme cathode, et l'admission de gaz étant mise au potentiel terrestre et la paroi du réacteur (1) étant connectée de façon anodique, de sorte que le produit réactionnel se présentant en tant que poudre peut être déposé sur le treillis connecté en tant que cathode ou sur la structure ayant l'aspect d'une surface ou sur des corps substrats y fixés.

2. Dispositif selon la revendication 1, caractérisé par le fait que le corps creux (4) possède une section intérieure libre de plus de 200 mm² et est pourvu de plus de 400 orifices d'échappement avec une section respective inférieure à 1 mm².

3. Dispositif selon la revendication 1 ou 2, caractérisé par le fait que plusieurs corps creux (4) sont disposés dans le réacteur (1).

4. Dispositif selon l'une des revendications 1 à 3, caractérisé par le fait que le ou les corps creux (4) sont cylindriques, en coupe transversale ovales ou polygonaux, en particulier quadrangulaires.

5. Procédé permettant le dépôt de matières solides, utilisant un procédé CVD activé par une décharge lumineuse au moyen de chlorures métalliques gazeux, d'hydrogène, d'oxygène et/ou d'azote et/ou d'un gaz contenant du carbone, qui est conduit à grande vitesse dans la chambre de réaction dans laquelle une pression de travail constante est maintenue, caractérisé par le fait que le gaz est introduit à une vitesse supérieure à 50 m/sec dans la chambre de réaction et est introduit radialement en dehors par l'intermédaire d'un corps creux (4) allongé, l'admission de gaz étant mise au potentiel terrestre, un treillis (7) disposé de façon coaxiale autour de cela ou une structure ayant l'aspect d'une surface, pourvue de beaucoup d'orifices étant connectés de manière cathodique et la paroi du réacteur (1) étant connectée anodiquement, de sorte que le produit réactionnel se présentant en tant que poudre est déposé sur le treillis connecté en tant que cathode ou sur la structure ayant l'aspect d'une surface ou sur des corps substrats y fixés.

6. Procédé selon la revendication 5, caractérisé par le fait que la pression de travail est comprise entre 100 et 500 Pa et que la vitesse d'échappement de gaz est supérieure à 200 m/sec.

7. Procédé selon la revendication 5 ou 6, caractérisé par le fait que l'on applique une tension continue pulsée au treillis (7).

8. Utilisation du procédé selon les revendications 1 à 7 pour le dépôt de poudres très fines d'oxydes, de carbures et de nitrures.

9. Utilisation du procédé selon les revendications 1 à 7 pour le dépôt de revêtements fortement adhérents d'oxydes, de carbures et de nitrures.

10. Utilisation selon les revendications 8 ou 9 pour le dépôt de revêtements fortement adhérents d'oxyde d'aluminium, de carbure de titane et de nitrure de titane.
